# EUROPEAN PATENT SPECIFICATION

(11) **EP 0 825 649 B1**
(45) Date of publication and mention of the grant of the patent: **14.01.2004**
(21) Application number: 97119007.9
(22) Date of filing: 07.12.1995
(51) Int. Cl.: H01L 25/07

(54) **Method of protecting during transportation the lead pins and guide pins of semiconductor devices**
Schutzverfahren für Leiter- oder Führungsstifte von Halbleiteranordnungen während des Transports
Procédé pour la protection des broches de connexion et de guide de dispositifs semi-conducteurs pendant le transport

(30) Priority: 08.12.1994 JP 30493394
(43) Date of publication of application: 25.02.1998
(62) Divisional of application: 95308874.7
(73) Proprietor: FUJI ELECTRIC CO. LTD., Kawasaki 210 (JP)
(72) Inventor: Soyano, Shin, Fuji Eletric Co., Ltd., Kawasaki 210 (JP); Toba, Susumu, Fuji Eletric Co., Ltd., Kawasaki 210 (JP)
(74) Representative: Bridge-Butler, Alan James

(56) References cited:
- EP-A- 0 476 355
- EP-A- 0 513 410
- EP-A- 0 591 631
- EP-A- 0 608 051
- US-A- 4 330 683
- US-A- 4 928 824
- PATENT ABSTRACTS OF JAPAN vol. 010, no. 192 (E-417), 5 July 1986 & JP 61 039557 A (HITACHI LTD), 25 February 1986

## Description

The present invention relates to a method of protecting during transportation the lead pins and guide pins of semiconductor devices called 'power modules' which house a circuit board on which semiconductor elements are mounted in an insulating casing.

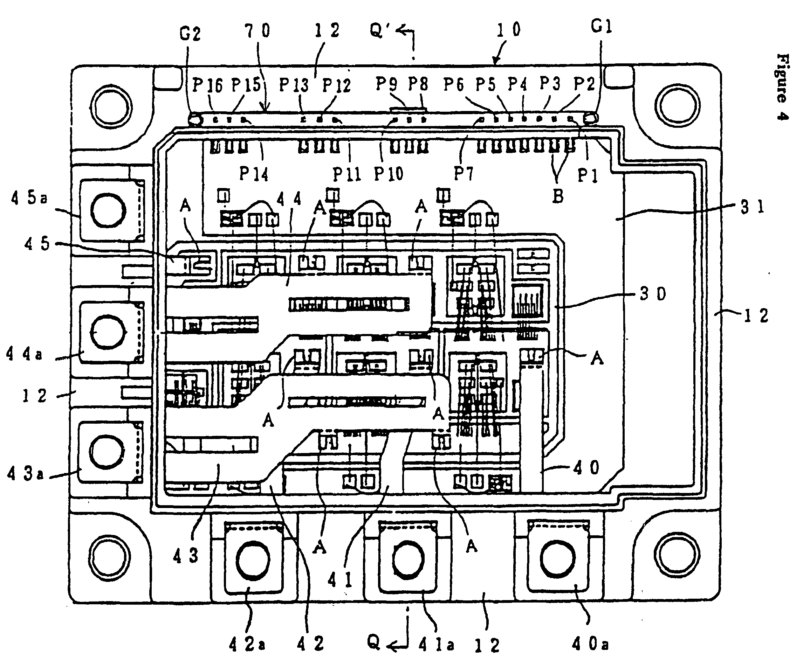

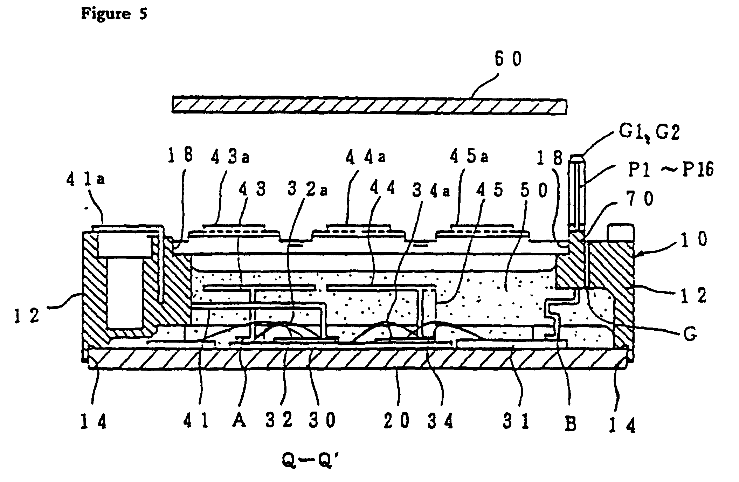

Figure 4 is a top plan view showing a structure of a conventional semiconductor device known as a 'power module' or an 'intelligent power module'. Figure 5 is a cross section along the line Q-Q' of Figure 4. As is shown in these Figures, the semiconductor device has an insulating casing 10 in the form of a frame 12 having opposed end openings and an inner face. A radiator base plate (for example a metal plate) 20 is bonded with an adhesive to a first opening step 14 formed on a first end of the frame 12 to close a first end opening of the casing 10. Circuit boards (ceramics boards) 30, 31 are bonded with a solder etc. to the interior face of the radiator base plate 20. Lead frames 40 to 45 are connected at their inner lead ends A to the land areas of the thick film wiring formed on the circuit board 30. A lead pin block 70, integrally formed with many lead pins P1 to P16 standing thereon, is fixed to the frame 12 of the insulating casing 10. The ends B of inner leads of the respective lead pins P1 to P16 are connected with thick film wiring formed on the circuit board 31. The circuit board 30, the inner leads of the lead frames 40 to 45, and the inner leads of the lead pins P1 to P16 are immersed in a gel resin sealant 50 such as silicone resin. An insulating cover plate 60 is bonded with an adhesive to a second opening step 18 formed on the second end of the frame 12 to close the second end opening of the casing 10. Semiconductor elements (chips) 32, 34 such as power transistors, IGBTs (conductivity modulation type transistors), diodes, thyristors, etc. are mounted on the circuit boards 30, 31. The inner lead ends A of the lead frames 40 to 45 are bonded with solder or the like to land portions of the thick film wiring of the circuit board 30, and connected through bonding wires 32a and 34a to the corresponding semiconductor elements 32 and 34.

The lead frames 40 to 45 are inserted into the frame 12 and fixed to the frame 12 at respective terminal washers 40a to 45a with terminal screws (not shown).

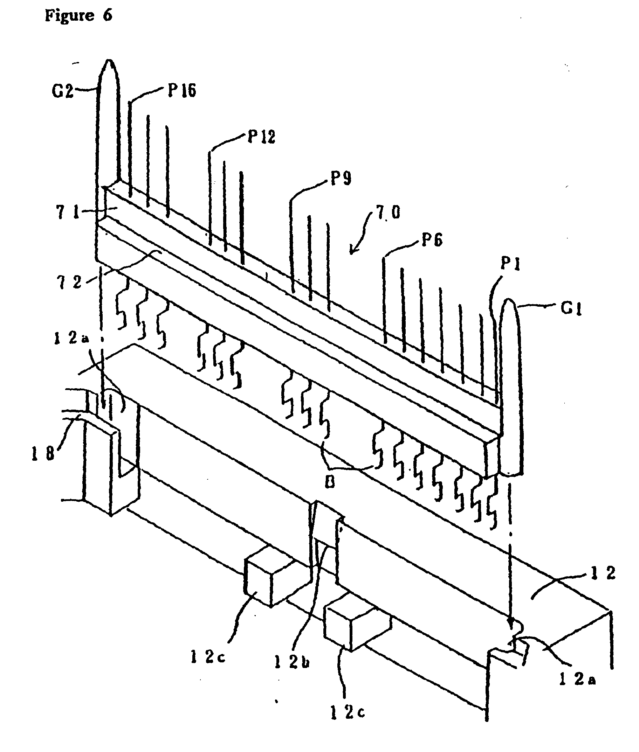

Figure 6 is an exploded isometric view showing the lead pin block and its installation structure. Referring now to Figure 6, the lead pin block 70 is an insert moulding, moulded separately from the insulating casing 10. The lead pin block 70 includes a base 71 on which the lead pins P1 to P16 stand, a step 72, a coupling claw (not shown) formed on the opposite side to the face on which the step 72 is formed, and guide pins G1 and G2. The upper face of the step 72 is positioned at the same height as the upper face of the second end opening step 18, when the guide pins G1 and G2 are inserted into respective slots 12a formed on the inner face of the frame 12 of the insulating casing 10, so as to accept the insulating cover plate 60. The coupling claw couples with a wedge-shaped coupling claw 12b formed on the inner face of the frame 12 to resist removal of the lead pin block once inserted. The guide pins G1 and G2 are inserted into respective guide holes formed on a female connector for the lead pins P1 to P16 (not shown). A pair of support pins 12c which locate and sustain the inserted lead pin block 70 at the predetermined height, are formed on the inner face of the frame 12. The lead pin block is moulded separately from the insulating casing 10 to reduce the volume of the resin moulding, and thus to minimise the influence of the shrinkage etc. of the resin. By this means, both the precision of the pitch between the lead pins and the verticalness of the lead pins P1 to P16 are improved, and therefore, the production yield of the semiconductor device is improved.

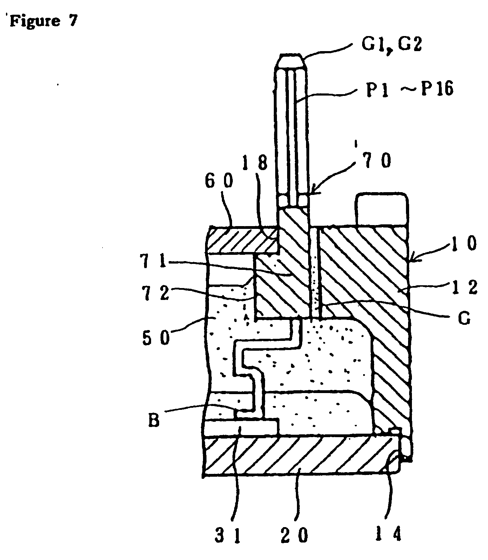

The lead pin block 70 is installed on the insulating casing 10 tightly enough so as not to come out easily by inserting the lead pin block 70 into the slots 12a, and by coupling together the coupling claw 12b of the frame 12 and the coupling claw of the lead pin block 70. Figure 7 is a partial cross section of the insulating casing with the lead pin block installed thereon. As shown in Figure 7, the insulating casing 10 is filled with the gel resin sealant 50 (such as silicone resin), and is then closed by the insulating cover plate 60, which is bonded with an adhesive to the second end opening step 18 of the insulating casing 10 and to the step 72 of the lead pin block 70.

The above described structure for installing the lead pin block 70 on the semiconductor module has the disadvantage that the gel resin sealant (silicone resin) 50 is heated up and expands due to the heating applied for bonding the insulating cover plate 60 to the insulating casing 10 or by the heat generated from the power elements of the operating semiconductor module, immersed in the gel resin sealant 50. The expanding gel resin sealant 50 spreads out through the insertion gap G between the base 71 of the lead pin block 70 and the inner face of the frame 12 or lifts up the insulating cover plate 60.

Another drawback is that since the lead pins P1 to P16 are extremely fine square rods less than 1 mm in width, the lead pins are easily bent by any unwanted contact etc. during transportation of the semiconductor module. Furthermore, the resin guide pins G1 and G2 are easily broken.

EP-A-0 591 631 shows a power semiconductor device having a power circuit and a control circuit incorporated in a resin case, the circuits being mounted on different substrates and interconnected internally by lead pins within the case. Power terminals and control terminals connected to the power control circuits respectively extend out of the case and together with lead pins are first moulded by an insert technique together with the case. The power terminals and control terminals are arranged at the peripheral edge of the case and the lead pins are arranged on a pin block provided at a middle portion within the case, the substrate for the power circuit is mounted on a heat dissipating metal base combined with the bottom of the case and the substrate for the control circuit on the pin block with the power terminals and control terminals and the pin block, with the power terminals, control terminals being soldered together. In this construction the power and control terminals extend out of the case but no protection for the terminals is provided and they can be easily bent when the item is packed or transported as referred to above.

In view of the foregoing, it is an object of the invention to provide a method of protecting the lead pins and guide pins during the transport of a semiconductor device.

According to the present invention a method of protecting during transportation the lead pins and guide pins of a semiconductor device which comprises an insulating casing (10) in the form of a frame (12) and having opposed end openings and an inner face; a lead pin block (80) having guide pins (G1,G2) and a base (81) with a plurality of lead pins (P1-P16) standing thereon, the lead pin block (80) being installed on the inner face of the frame, and the lead pins (P1-P16) having respective inner leads; a radiator base plate (20) closing a first end opening of the insulating casing; a circuit board (30,31) whereon are mounted semiconductor chips (32,34) connected to the ends (B) of the inner leads, the circuit board (30,31) being bonded to the interior face of the radiator base plate (20); a gel resin sealant (50) in which the circuit board (30,31) and the inner leads are immersed, the gel resin sealant (50) substantially filling the inner space of the insulating casing; an insulating cover plate (60) closing the second end opening of the insulating casing (10); characterised by providing a sheath block (90) having a plurality of lead holes (h1 to h22) and a plurality of guide holes (H1,H2) into which said lead pins (P1-P16) and guide pins (G1,G2) can respectively be freely inserted and removed over said lead and guide pins, and locating said sheath block over said lead and guide pins so as to protect said lead and guide pins during transportation of said semiconductor device.

Preferably the method includes using stopper protrusions (84) on the base (81) of the lead pin block (80) to limit the insertion depth of the sheath block over said lead and guide pins.

The method can also include using steps (92) in the vicinity of the guide holes (H1,H2) on the contact face (90a) of the sheath block (90) facing the base block when located over said lead and guide pins.

Moreover a sheath block can be used with a first guide hole located on a first end thereof, a second guide hole located on a second end thereof, a third guide hole located midway in the alignment of the lead pins, and at least one weakened section provided by a recess for partitioning located in the vicinity of the third guide hole.

The lead pins and the guide pins are completely covered by the sheath block by inserting the sheath block onto the lead pins and the guide pins. The sheath block avoids anything from coming into direct contact with the pins during transport and prevents the pins from bending or breaking. The stopper protrusions are formed on the upper face of the base of the lead pin block to limit the extent to which the sheath block can be pushed onto the lead pins, to secure a minimum clearance distance between the pins of circuit terminal groups on one side of an arm. When the sheath block is inserted, the contact face touches the stopper protrusions leaving a gap around the roots of the pins. This gap facilitates pulling out the inserted sheath block. When a guide pin is broken, the broken guide pin is repaired by bonding with an adhesive. However, the adhesive sometimes spreads away from the repaired guide pin and solidifies at locations which make it difficult to insert the sheath block completely. The relief space for the spreading adhesive, formed by the provision of the steps on the contact face of the sheath block adjacent to the respective guide holes, facilitates inserting the sheath block completely. By using the sheath block which has the third guide hole and at least one recess for partitioning, guide blocks having different number of lead pins can easily be accommodated. This type of sheath block is divided along the recess when the counterpart lead block has a smaller number of lead pins.

Preferred methods of performing the present invention will now be described by way of example and with reference to the accompanying drawings, in which:
Figure 1(a) is a cross-section of a semiconductor device to which the method of the present invention can be applied;
Figure 1(b) is a partial cross section showing the installation structure for the lead pin block of Figure 1(a);
Figure 2 is an exploded isometric view showing the installation structure for the lead pin block;
Figure 3(a) is a top plan view of a second sheath block for use in the method of the present invention;
Figure 3(b) is a front view of the sheath block of Figure 3(a);
Figure 4 is a top plan view showing a structure of a conventional semiconductor device called a 'power module' or an 'intelligent power module' on which the present method can be employed;
Figure 5 is a cross section along Q-Q' of Figure 4;
Figure 6 is an exploded isometric view showing the lead pin block and its installation structure according to the prior art; and
Figure 7 is a partial cross section of the insulating casing with the lead pin block installed thereon according to the prior art.

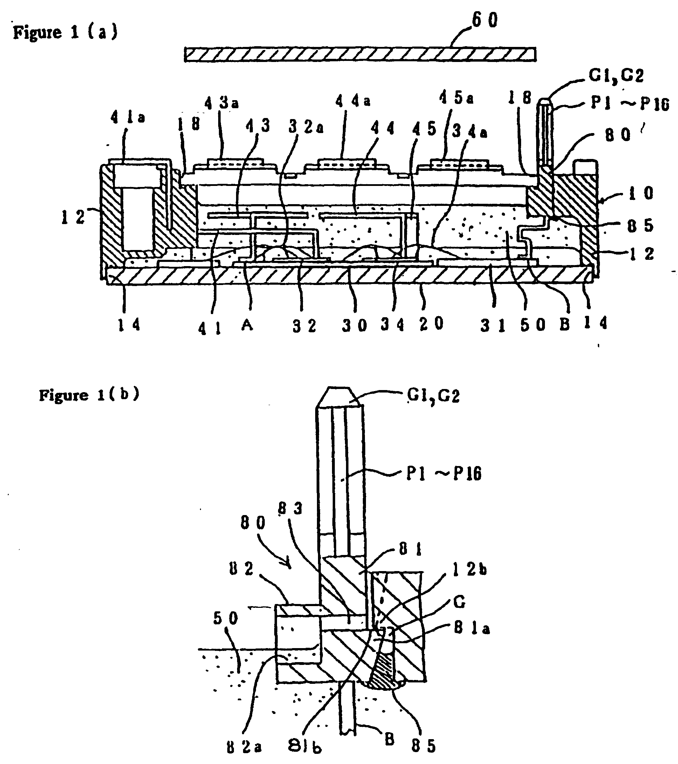

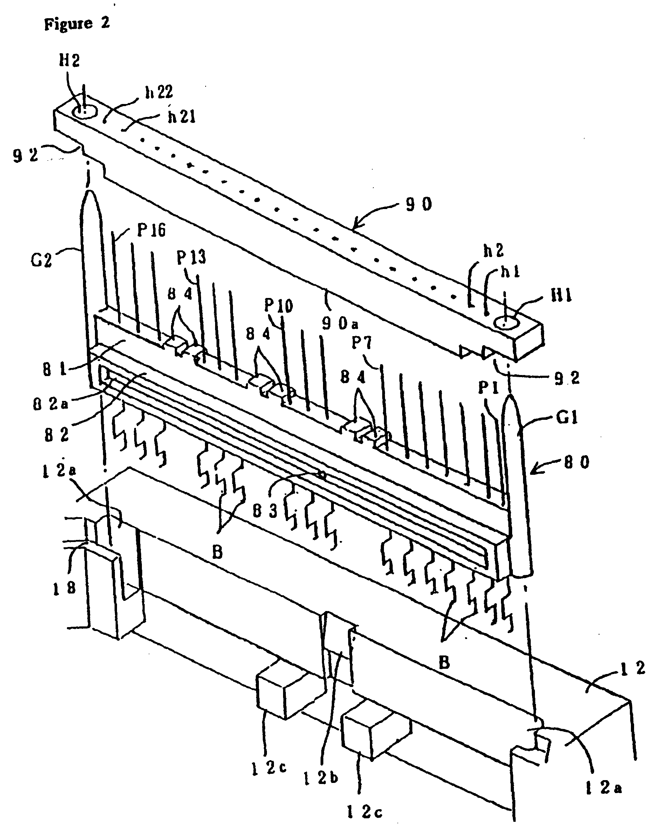

Referring now to the Figures, Figure 1(a) is a cross section of a semiconductor device to which the method of the present invention can be applied. Figure 1(b) is a partial cross section showing the installation structure for the lead pin block of Figure 1(a), and Figure 2 is an exploded isometric view showing the installation structure for the lead pin block and the sheath block.

The semiconductor device is called a 'power module' or an 'intelligent power module' and has a two-dimensional layout similar to that shown in Figure 4. Referring now to Figures 1(a) and 1(b), the semiconductor device has an insulating casing 10 in the form of a frame 12 having opposed end openings and an inner face. A heat-dissipating base plate 20 (preferably a metal plate) is bonded with an adhesive to a first end opening rebate or step 14 formed on the first end of the frame 12, to close the first end opening of the casing 10. Circuit boards (ceramics boards) 30, 31 are bonded with for example solder etc. to the interior face of the base plate 20. Lead frames 40 to 45 are connected at their inner lead ends A to the thick film wiring formed on the circuit board 30. The lead frames 41, 43, 44 and 45 are shown in Figure 1(a). A lead pin block 80, which is an insert moulding integrated with lead pins P1 to P16 standing thereon, is fixed to the frame 12 of the insulating casing 10. The ends B of inner leads of the respective lead pins P1 to P16 are connected with thick film wiring formed on the circuit board 31. The circuit board 30, the inner leads of the lead frames 40 to 45, and the inner leads of the lead pins P1 to P16 are immersed in a gel resin sealant (for example silicone resin) 50. An insulating cover plate 60 is bonded with an adhesive to a second end opening step 18 formed on the second end of the frame 12 to close the second end opening of the casing 10. Semiconductor elements (chips) 32, 34 such as power transistors, IGBTs (conductivity modulation type transistors), diodes, thyristors, etc. are mounted on the circuit boards 30 and 31. The inner lead ends A of the lead frames 40 to 45 are bonded for example by soldering etc. to the land portions of the thick film wiring of the circuit board 30, and are connected through bonding wires 32a and 34a to the corresponding semiconductor elements 32 and 34. The lead frames 40 to 45 are inserted into and fixed to the frame 12 at respective terminal washers 40a to 45a with terminal screws (not shown).

Referring now to Figure 1(b) and Figure 2, the lead pin block 80 is an insert moulding moulded separately from the insulating casing 10. The lead pin block 80 includes a base 81 on which the lead pins P1 to P16 stand; a step 82; a first coupling claw 81a having a latch portion 81b formed on the opposite face of the base 81 to the face on which the step 82 is formed; guide pins G1 and G2; an air vent 83 formed through the base 81 from a recess 82a of the step 82 to the latch portion 81b of the coupling claw 81; and a plurality of stopper protrusions 84 formed on the upper face of the base 81. The upper face of the step 82 is positioned at the same height as the upper face of the second opening step 18, when the guide pins G1 and G2 are inserted into respective slots 12a formed on the inner face of the frame 12 of the insulating casing 10, so as to accept the insulating cover plate 60. The coupling claw 81a couples with a wedge-shaped coupling claw 12b formed on the inner face of the frame 12 (see Figure 1(b)). The guide pins G1 and G2 are inserted into respective guide holes formed on a female connector for the lead pins P1 to P16 (not shown).

The lead pin block 80 is installed on the insulating casing 10 tightly enough so as not to come out easily, by inserting the lead pin block 80 into the slots 12a and by coupling the coupling claw 12b of the frame 12 and the coupling claw 81a of the lead pin block 80 with one another. In this embodiment, the insertion gap G between the lead pin block 80 and the frame 12 is closed with a sealant or adhesive etc. 85 on the side of the interior space of the casing 10, which communicates to the outside through the air vent 83.

Thus, the insertion gap G between the lead pin block 80 and the frame 12 is closed on the side of the interior space of the casing 10 in that the lead pin block 80 is inserted into the slots 12a and installed on the casing 10. The gel resin sealant 50, although it may be heated and expanded by the heat generated from the semiconductor chips 32 and 34, never spreads out through the gap G. As the gel resin sealant 50 thermally expands, the air pressure in the interior tends to rise. However, the air vent 83 prevents the internal pressure from rising, and the free surface level of the gel resin sealant 50 rises with no problems as the gel expands. Thus, excessive thermal stress and lifting up of the insulating cover plate 60 are prevented, and the reliability of the semiconductor device is improved. In this embodiment, the air vent 83 is formed across the latch portion 81b of the coupling claw 81a so that the air vent can communicate with the outside through the gap of the coupling claw 12b formed on the side of the casing 10. The lead pin block 80 with the air vent 83 formed therein is manufactured by injection moulding in a simple mould with no moving cores, by forming the air vent 83 across the step portion of the coupling claw 81a of the thus moulded lead pin block. Since the mould construction is simplified, the manufacturing cost of the semiconductor device is reduced.

As shown in Figure 2, a sheath block 90 made of resin has lead holes h1 to h22 corresponding to the lead pins P1 to P16 and guide holes H1 and H2 corresponding to the guide pins G1 and G2. The lead pins P1 to P16 are freely insertable into and removable from the lead holes h1 to h22. The guide pins G1 and G2 are freely insertable into and removable from the guide holes H1 and H2. And, double-steps 92, 92, respectively having two steps thereon, are formed on a contact face 90a of the sheath block 90 on the sides of the respective guide holes H1 and H2.

The lead pins and the guide pins are completely covered by a sheath block, by inserting a sheath block 90 onto the lead pins P1 to P16 and the guide pins G1 and G2. The sheath block 90 prevents anything from coming into direct contact with the pins during the transport and prevents the pins from bending or breaking. Stopper protrusions 84 are formed on the upper face of the base 81 of the lead pin block 80 to define the distance between the circuit terminal groups of one side of an arm. When the sheath block 90 is inserted, a contact face 90a touches the stopper protrusions 84 leaving a gap around the roots of the pins. The gap between the sheath block and the base 81 facilitates the removal of the inserted sheath block 90.

If either guide pin G1 or G2 is broken, the broken guide pin is repaired by bonding its parts back together with an adhesive. However, the adhesive sometimes spreads away from the repaired guide pin and sticks to the adjacent areas of the base 81, making it difficult to insert the sheath block completely. To avoid this problem, double steps 92 are formed on the contact face 90a of the sheath block 90 to the sides of the respective guide holes H1 and H2 so as to provide a relief space to accommodate any excess adhesive. Thus, the sheath block 90 can be inserted easily onto a repaired guide pin.

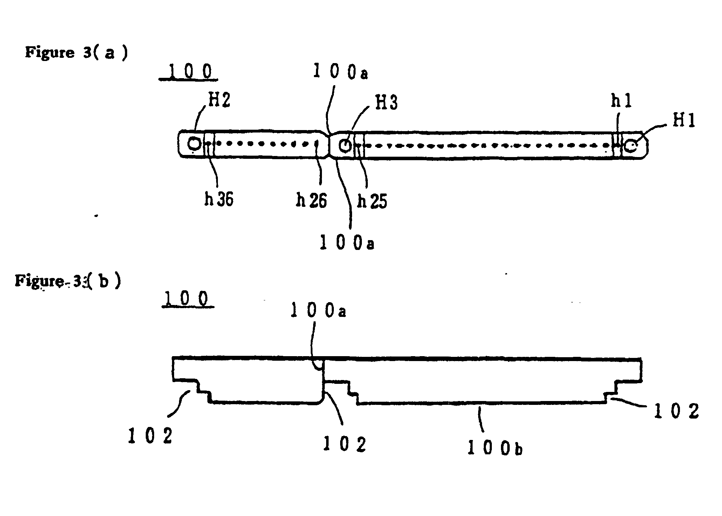

Figure 3(a) is a top plan view of another sheath block, and Figure 3(b) is a front plan view of the sheath block of Figure 3(a). This sheath block 100 has a first guide hole H1 formed on an end of the sheath block 100, a second guide hole H2 formed on another end of the sheath block 100, and a third guide hole H3 formed at a location midway in the alignment of guide holes h1 to h36. The guide holes h1 to h25 are aligned between the first guide hole H1 and the third guide hole H3. Recesses 100a for partitioning are formed on the front and rear faces of the sheath block 100 between the third guide hole H3 and the guide pin 26. Double steps (like steps 92) are formed on a contact face 100b of the sheath block 100 near the guide holes H1 and H2 and H3.

This sheath block 100 copes with lead pin blocks having different number of lead pins thereon. For protecting a lead pin block having 36 lead pins thereon, the sheath block 100 is used in the state as shown in Figures 3(a) and 3(b). For protecting a lead pin block having 25 lead pins thereon, the sheath block 100 is divided by snapping the weakened section between the recesses 100a, 100a, and the portion that has the guide holes H1 and H3 is used. Thus, the sheath block 100 facilitates reducing the cost of the mould.

As has been explained above, the method according to the invention includes the use of a sheath block that covers and protects the pins standing on the lead pin block.

Since the lead pins and the guide pins of the lead pin block are completely covered by the sheath block when the sheath block is placed onto the lead pins and the guide pins, the pins are protected from contact, deformation, and breaking during the transport.

Provision of the stopper protrusions formed on the upper face of the base of the lead pin block means that a gap is left around the roots of the pins, and thus the inserted sheath block may be easily removed.

Since a relief space for the spreading adhesive is left by forming the double-steps, respectively having two steps thereon, on the contact face of the sheath block adjacent to the respective guide holes, complete insertion of the sheath block is facilitated even when broken guide pins have been repaired by adhesive bonding.

By using the sheath block that has the third guide hole and recesses for partitioning, it is possible to cope with guide blocks having different numbers of lead pins. This type of sheath block is divided along the recesses when the lead block to which it is to be applied has a lesser number of lead pins.

## Claims

1. A method of protecting during transportation the lead pins and guide pins of a semiconductor device which comprises
an insulating casing (10) in the form of a frame (12) and having opposed end openings and an inner face;
a lead pin block (80) having guide pins (G1,G2) and a base (81) with a plurality of lead pins (P1-P16) standing thereon; the lead pin block (80) being installed on the inner face of the frame, and the lead pins (P1-P16)having respective inner leads;
a radiator base plate (20) closing a first end opening of the insulating casing;
a circuit board (30,31) whereon are mounted semiconductor chips (32,34) connected to the ends (B) of the inner leads, the circuit board (30,31) being bonded to the interior face of the radiator base plate (20);
a gel resin sealant (50) in which the circuit board (30,31) and the inner leads are immersed, the gel resin sealant (50) substantially filling the inner space of the insulating casing;
an insulating cover plate (60) closing the second end opening of the insulating casing (10);
**characterised by** providing a sheath block (90) having a plurality of lead holes (h1 to h22) and a plurality of guide holes (H1,H2) into which said lead pins (P1-P16) and guide pins (G1,G2) can respectively be freely inserted and removed over said lead and guide pins, and locating said sheath block over said lead and guide pins so as to protect said lead and guide pins during transportation of said semiconductor device.

2. A method as claimed in claim 1 **characterised by** using stopper protrusions (84) on the base (81) of the lead pin block (80) to limit the insertion depth of the sheath block over said lead and guide pins.

3. A method as claimed in claim 1 or claim 2 **characterised by** using steps (92) in the vicinity of the guide holes (H1,H2) on the contact face (90a) of the sheath block (90) facing the base block when located over said lead and guide pins.

4. A method as claimed in claim 1, claim 2 or claim 3 **characterised by** using a sheath block (90) which has a first guide hole (H1) located on a first end thereof, a second guide hole (H2) located on a second end thereof, a third guide hole (H3) located midway in a line of the lead pins (P1-P16), and at least one weakened section provided by a recess (100a) for partitioning located in the vicinity of the third guide hole (H3).

## Patentansprüche

1. Ein Verfahren zum Schutz der Anschlussstifte und Führungsstifte eines HalbleiterBauelements während des Transports, welches umfasst
ein Isolationsgehäuse (10) in der Form eines Rahmens (12), welches gegenüberliegende Endöffnungen und eine innere Oberfläche hat;
einen Anschlussstiftblock (80) welcher Führungsstifte (G1, G2) und eine Basis (81) mit einer Vielzahl daraufstehender Anschlussstifte (P1-P16) hat, wobei der Anschlussstiftblock (80) an der inneren Oberfläche des Rahmens angebracht ist, und die Anschlussstifte (P1-P16) haben entsprechende innere Anschlüsse;
eine Kühlbasisplatte (20), welche eine erste Endöffnung des Isolationsgehäuses abschließt;
eine Schaltkreisplatte (30, 31) auf der Halbleiterchips (32, 34) befestigt sind, welche mit den Enden (B) der inneren Anschlüsse verbunden sind, wobei die Schaltkreisplatte (30, 31) mit der inneren Oberfläche der Kühlbasisplatte (20) verbunden ist;
eine Harzgeldichtung (50) in welche die Schaltkreisplatte (30, 31) und die inneren Anschlüsse eingelassen sind, wobei die Harzgeldichtung (50) im wesentlichen den inneren Raum des Isolationsgehäuses füllt;
eine Isolationsabdeckplatte (60), welche die zweite Endöffnung des Isolationsgehäuses (10) verschließt;
**gekennzeichnet durch** Bereitstellen eines Umhüllungsblocks (90), welcher eine Vielzahl von Anschlußlöchern (h1-h22) und eine Vielzahl von Führungslöchern (H1, H2) hat, in welche die Anschlussstifte (P1-P16) und die Führungsstifte (G1, G2) ungehindert eingeführt werden können bzw. welcher ungehindert von den Anschluss- und Führungsstiften entfernt werden kann, und Anordnen des Umhüllungsblocks über die Anschluss- und Führungsstifte derart, um die Anschluss- und Führungsstifte während des Transports des Halbleiterbauelements zu schützen.

2. Verfahren nach Anspruch 1, **dadurch gekennzeichnet, dass** Stopp-Vorsprünge (84) auf der Basis (81) des Anschlussstiftblocks (80) benutzt werden, um die Einsetztiefe des Umhüllungsblocks auf die Anschluss- und Führungsstifte zu begrenzen.

3. Verfahren nach Anspruch 1 oder 2, **dadurch gekennzeichnet, dass** Stufen (92) in der Nähe der Führungslöcher (H1, H2) auf der Kontaktoberfläche (90a) des Umhüllungsblocks (90) benutzt werden, welche dem Basisblock zugewandt sind, wenn sie sich oberhalb der Anschluss- und Führungsstifte befinden.

4. Verfahren nach Anspruch 1, 2 oder 3, **dadurch gekennzeichnet, dass** ein Umhüllungsblocks (90) benutzt wird, der ein erstes Führungsloch (H1) an seinem ersten Ende aufweist, der ein zweites Führungsloch (H2) an seinem zweiten Ende aufweist, der ein drittes Führungsloch (H3) mittig in einer Linie der Anschlussstifte (P1-P16) aufweist, und der mindestens einen der Aufteilung dienenden dünneren Abschnitt, welcher durch eine Ausnehmung (100a) gebildet wird, in der Nähe des dritten Führungslochs (H3) aufweist.

## Revendications

1. Procédé pour protéger, pendant le transport, les broches de connexion et les broches de guidage d'un dispositif à semi-conducteurs qui comprend
un boîtier isolant (10) sous la forme d'un châssis (12) et ayant des ouvertures d'extrémités opposées et une face intérieure ;
un bloc (80) de broches de connexion ayant des broches de guidage (G1, G2) et un socle (81) sur laquelle se tiennent plusieurs broches de connexion (P1-P16), le bloc (80) de broches de connexion étant installé sur la face interne du châssis, et les broches de connexion (P1-P16) ayant des conducteurs intérieurs respectifs ;
une embase (20) de radiateur fermant une première ouverture d'extrémité du boîtier isolant ;
une carte (30, 31) de circuit sur laquelle sont montées des puces (32, 34) à semi-conducteurs connectées aux extrémités (B) des conducteurs intérieurs, la carte (30, 31) de circuit étant fixée à la face interne de l'embase (20) de radiateur ;
une résine d'étanchéité gélifiée (50) dans laquelle sont noyés la carte (30, 31) de circuit et les conducteurs intérieurs, la résine d'étanchéité gélifiée (50) remplissant sensiblement l'espace intérieur du boîtier isolant ;
une plaque de couverture isolante (60) fermant la seconde ouverture d'extrémité du boîtier isolant (10) ;
**caractérisé par** les étapes consistant à réaliser, au-dessus desdites broches de connexion et de guidage, un bloc de protection (90) ayant une pluralité de trous (h1 à h22) pour conducteurs et une pluralité de trous de guidage (H1, H2) dans lesquels lesdites broches de connexion (P1-P16) et broches de guidage (G1, G2) peuvent respectivement être librement insérées et retirées, et placer ledit bloc de protection sur lesdites broches de connexion et de guidage afin de protéger lesdites broches de connexion et de guidage pendant le transport dudit dispositif à semi-conducteurs.

2. Procédé selon la revendication 1, **caractérisé par** l'utilisation de saillies d'arrêt (84) sur le socle (81) du bloc (80) de broches de connexion pour limiter la profondeur d'insertion du bloc de protection par-dessus lesdites broches de connexion et de guidage.

3. Procédé selon la revendication 1 ou la revendication 2, **caractérisé par** l'utilisation de gradins (92) voisins des trous de guidage (H1, H2) sur la face de contact (90a) du bloc de protection (90) en regard du bloc de socle lorsqu'il est placé sur lesdites broches de connexion et de guidage.

4. Procédé selon la revendication 1, la revendication 2 ou la revendication 3, **caractérisé par** l'utilisation d'un bloc de protection (90) qui possède un premier trou de guidage (H1) situé à une première extrémité de celui-ci, un deuxième trou de guidage (H2) situé à une deuxième extrémité de celui-ci, un troisième trou de guidage (H3) situé à mi-distance sur une ligne des broches de connexion (P1-P16), et au moins une zone affaiblie constituée par une encoche de division (100a) située au voisinage du troisième trou de guidage (H3).
